(19) Europäisches Patentamt
European Patent Office
Office européen des brevets

(11) EP 0 631 376 B1

(12) **EUROPÄISCHE PATENTSCHRIFT**

(45) Veröffentlichungstag und Bekanntmachung des Hinweises auf die Patenterteilung:
**16.12.1998  Patentblatt 1998/51**

(51) Int Cl.$^6$: **H03C 3/00**

(21) Anmeldenummer: **94108901.3**

(22) Anmeldetag: **10.06.1994**

(54) **Verfahren zur Frequenzmodulation**

Method for frequency modulation

Procédé de modulation de fréquence

(84) Benannte Vertragsstaaten:
**AT CH DE ES FR GB IT LI NL**

(30) Priorität: **24.06.1993  DE 4320999**

(43) Veröffentlichungstag der Anmeldung:
**28.12.1994   Patentblatt 1994/52**

(73) Patentinhaber: **ROBERT BOSCH GMBH**
**70442 Stuttgart (DE)**

(72) Erfinder: **Göckler, Heinz, Dr.**
**D-71522 Backnang (DE)**

(56) Entgegenhaltungen:
**EP-A- 0 419 680          EP-A- 0 508 661**
**DE-A- 4 026 476          US-A- 5 111 163**

- **PATENT ABSTRACTS OF JAPAN vol. 11 no. 249 (E-532) ,13. August 1987 & JP-A-62 062603 (MATSUSHITA ELECTRIC IND CO) 19. März 1987,**

## Beschreibung

Die Erfindung bezieht sich auf ein Verfahren zur FM-Modulation gemäß Oberbegriff des Patentanspruches 1. Solche Verfahren sind bekannt, beispielsweise aus der Europäischen Offenlegungsschrift EP-A-508 661, die einen FM-Modulator beschreibt, der zur Erzeugung eines frequenzmodulierten Signales digitale Mittel in beschränkter Form benutzt, z.B. einen rückgekoppelten Phasenakkumulator zur Erzeugung eines digitalen frequenzmodulierten Signales und einen Trägeroszillator, welcher aus einer Tabelle Sinus- oder Cosinuswerte der Trägerschwingung ausliest. Dieser bekannte FM-Modulator gestattet zwar die beliebige Einstellung von Frequenzhub und Mittenfrequenz und zwar unabhängig voneinander, weist aber eine Reihe von Nachteilen auf wie z.B. Drift- und Alterungs- Probleme, nichtlineare Verzerrungen, das Erfordernis eines Abgleiches usw., welche alle daher rühren, daß der wesentliche Schaltungsaufwand dieses Modulators auf analoge Weise realisiert ist.

Beispiele von digitalen Frequenzmodulatoren sind bekannt z.B. aus EP-A-419 680 oder JP-A-62-062603.

Der Anmeldung lag die Aufgabe zugrunde, ein Verfahren zur FM-Modulation eines digitalen NF-Signals der Eingangs genannten Art anzugeben, welches die genannten Nachteile nicht aufweist.

Durch die volldigitale Realisierung des erfindungsgemäßen FM-Modulators ergeben sich die Vorteile,

daß Drift- und Alterungsprobleme entfallen, daß kein Abgleich erforderlich ist, wodurch Personal- und zeitintensive Aufwände entfallen,
daß eine volle Integrationsfähigkeit als VLSI- bzw. ASIC-Baustein möglich ist,
daß nichtlineare Verzerrungen minimal sind,
daß eine Anwendung sowohl in volldigitaler als auch in analoger bzw. halbanaloger Umgebung möglich ist, letztere durch eine Ausstattung am Ein- oder Ausgang mit Analog-/Digital- bzw. Digital-/Analog-Umsetzung.

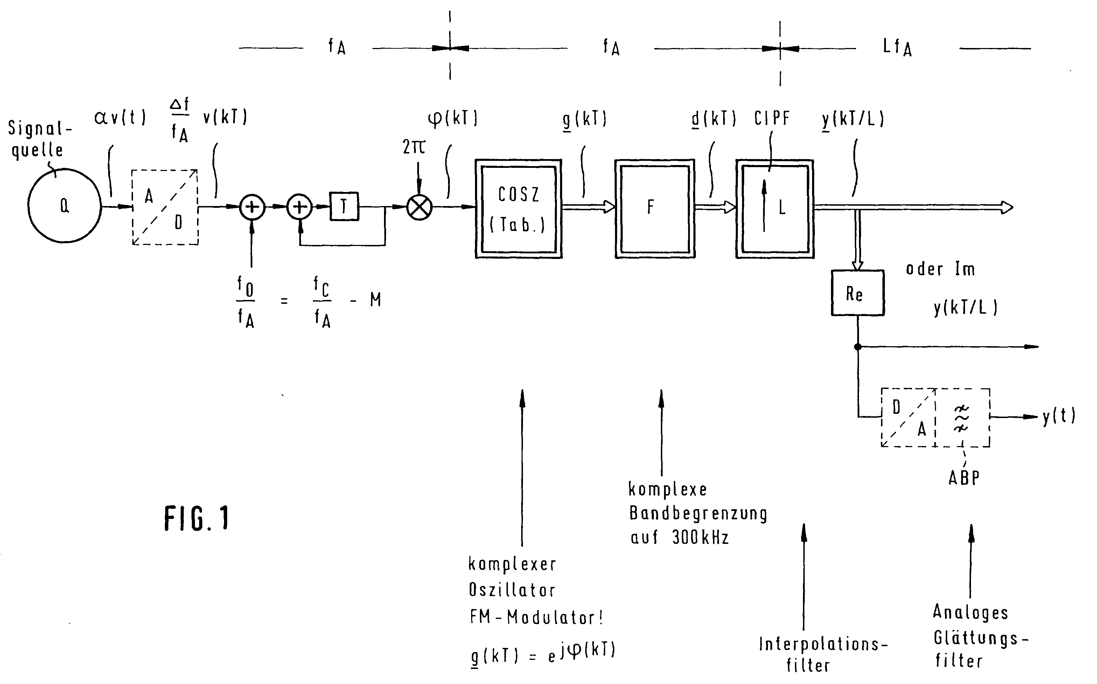

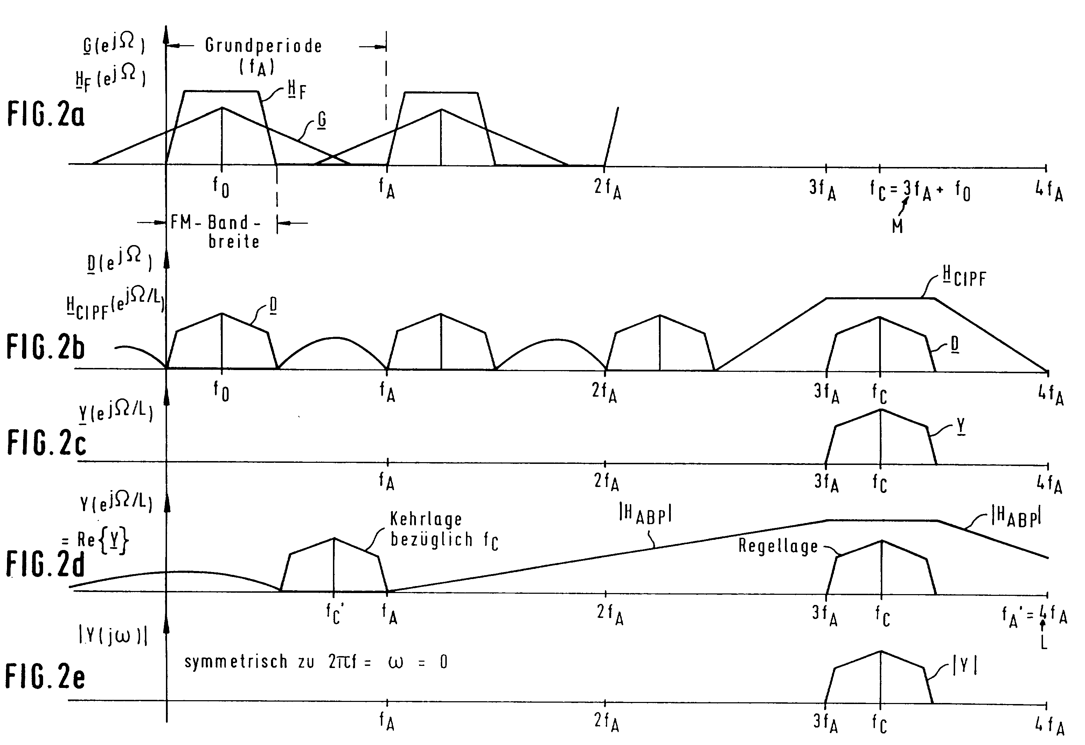

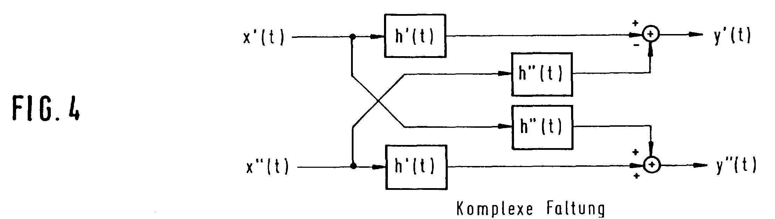

Es folgt die Beschreibung der Erfindung anhand der Figuren. Das Prinzip des erfindungsgemäßen Verfahrens ist anhand der Figur 1 erläuterbar, die das Blockschaltbild eines FM-Modulators, volldigital realisiert, zeigt. Die Figuren 2a bis 2e geben Spektren und Übertragungsfunktionen an einzelnen Punkten bzw. einzelner Bausteine der Figur 1 wieder. Die Figur 4 veranschaulicht die komplexe Faltung.

Die Signalquelle Q in Fig. 1 liefert ein analoges bandbegrenztes Signal $\alpha \cdot v(t)$, welches durch einen Analog-Digital-Umsetzer anschließend digitalisiert wird, oder unmittelbar ein digitales Signal $v(kT) \cdot \Delta f/f_A$, wobei $T = 1/f_A$ das Abtastintervall ist, das nachfolgend einen Träger der Frequenz $f_C$ bzw. der FM-Mittenfrequenz $f_0$ in der Frequenz moduliert mit dem Frequenzhub $\Delta f$. Dem digitalen modulierenden Signal $v(kT)$ mit $k = 0,1,...$ wird zunächst eine Konstante $f_0/f_A$ hinzu addiert, mit der die ausgangsseitig erwünschte Kanalmittenfrequenz $f_C = M \cdot f_A + f_0$ festgelegt wird, wobei M eine ganze Zahl ist. Damit ergibt sich die auf die Abtastfrequenz normierte Momentanfrequenz des FM-Signals in der Zwischenfrequenzlage um $f_0$ zu

$$\frac{f(k)}{f_A} = \frac{f_0}{f_A} + \frac{\Delta f}{f_A} \cdot v(k) \tag{1},$$

wobei der Term $k \cdot T$ abkürzend durch k, den laufenden Zeit- bzw. Abtastindex, ersetzt wurde. Die Größe $\Delta f$ ist der Frequenzhub, der unabhängig von $f_0$ wählbar ist und der angibt, um wieviel die Momentanfrequenz des modulierenden FM-Signals maximal von der Schwerpunktfrequenz $f_0$ (das ist die Frequenz des unmodulierten Signals) abweichen kann, wenn ohne Einschränkung der Allgemeinheit

$$\max. \{ v(k)\} \cong 1$$

gesetzt wird.

Aus (1) folgt die momentane Phase des FM-Signals durch Integration, was im Digitalen durch den idealen Integrator nämlich durch einen rückgekoppelten Akkumulator, realisiert wird mit nachfolgender Multiplikation mit $2\pi$:

$$\dot{\varphi}(kT) = 2\pi \sum_{\varkappa=0}^{k} [f_0/f_A + v(k) \cdot \triangle f/f_A]$$

$$= 2\pi \ kf_0/f_A + 2\pi \triangle f/f_A \sum_{\varkappa=0}^{k} v(\varkappa)$$

$$= \omega_0 \ kT \qquad + \triangle \Omega \ T \sum_{\varkappa=0}^{k} v(\varkappa) \qquad (2)$$

Anschließend erfolgt die komplexe Trägererzeugung und -Umsetzung, wobei aus einer Tabelle das komplexwertige FM-Signal

$$\underline{g}(k) = e^{j \ \varphi(k)} = g_r(k) + jg_i(k)$$

$$= \cos [\varphi(k)] + j \sin [\varphi(k)] \qquad (3)$$

ausgelesen wird. Die komplexwertigen Signale sind in Figur 1 und Figur 2 durch Unterstreichung und in Figur 1 ihre Signalpfade durch Doppel-Striche bzw. Doppel-Pfeile und die Bausteine mit komplexwertigen Koeffizienten wie Filter, Tabellen usw. mit doppelter Berandung gekennzeichnet.

$j = \sqrt{-1}$, zuerst in Gleichung 3 verwendet, ist die Imaginäreinheit, die rechnerisch nur implizit zu berücksichtigen ist. Ein komplexwertiges Signal stellt ein Signal dar, das aus zwei Komponenten, nämlich dem Real- und dem Imaginärteil zusammengesetzt ist.

Das FM-Signal g(k) ist idealerweise nicht bandbegrenzt, weshalb es durch ein Filter F mit komplexen Koeffizienten so bandzubegrenzen ist, daß die Systemanforderungen bezüglich Nachbarkanalstörungen eingehalten werden (bei UKW Bandbreite 300 kHz): Das Ergebnis am Filterausgang $\underline{d}(k)$.

Danach folgt ein Interpolations-Filter CIPF mit komplexen Koeffizienten, welches die Abtastfrequenz $f_A$ um den erforderlichen Faktor L erhöht, so daß am Filterausgang nur das gewünschte FM-Signal y(kT/L) um

$$f_C/f_A = M + f_0/f_A \qquad (4)$$

erscheint im Bereich $[0, L \cdot f_A]$. Das bedeutet, daß das komplexe Interpolations-Filter CIPF um $f_C$ einen Durchlaßbereich aufweisen und bei bezüglich $f_A$ periodischen Spektralanteilen sperren muß.

Wird nun im System nur ein reelles FM-Signal benötigt, so wird lediglich der Realteil oder der Imaginärteil weiter verwendet. Gegebenenfalls kann eine Digital-Analog-Umsetzung erforderlich sein, der dann üblicherweise ein analoges Glättungs-Filter ABP (meistens Tiefpass, aber auch Bandpass) folgt.

Die Funktionsweise des beschriebenen FM-Modulators wird nun im Frequenzbereich spektralmäßig erläutert. In den Figuren 2a bis 2e sind die Spektren jeweils mit den entsprechenden Großbuchstaben bezeichnet und beispielhaft Werte für M = 3 und L = 4 angesetzt.

Durch die Fouriertransformation sind Übertragungsfunktion und Impulsantwort bzw. Frequenz- und Zeitbereich miteinander verbunden:

$$\underline{G}(e^{j\Omega}) \circ\!\!-\!\!-\!\!-\!\!\circ \ \underline{g}(kT) \qquad (5)$$

Am Ausgang des komplexen Oszillators COSZ entsteht das Spektrum $\underline{G}(e^{j\Omega})$, siehe Figur 2a, das mit dem Filter F auf die zulässige Bandbreite begrenzt wird zu $\underline{D}(e^{j\Omega})$, siehe Figur 2b. Falls die Mittenfrequenz $f_0 = 0$ ist, sind Filterfunktion und Spektrum bezüglich f = 0 bzw. bezüglich $f_A$ nichtsymmetrisch (Eigenschaften komplexwertiger Signale). Das Interpolations Filter CIPF selektiert den gewünschten Spektralanteil um $f_C$, was möglich ist, da es auf die erhöhte Abtastfrequenz $L \cdot f_A = 4f_A$ bezogen ist (siehe $\underline{D}$ am Eingang von CIPF, Figur 2b, und $\underline{Y}$ am Ausgang von CIPF, Figur 2c).

Wird nur der Real- oder Imaginärteil weiter verwendet, so ergibt sich das Spektrum Y gemäß Figur 2d. Dieses Spektrum Y ist mit den gezeichneten Spektren symmetrisch sowohl bezüglich f = 0 als auch $f_A'/2 = 2f_A$, da es sich hier im Unterschied zur Figur 2a bis 2c um ein reelles Signal handelt. Dasselbe gilt auch für das analoge Signal y(t) beziehungsweise für sein Spektrum IYI nach einer Digital-Analog-Umsetzung DAU mit nachfolgendem Glättungs-Filter ABP, siehe Figur 2e.

Wie aus den bisherigen Ausführungen und auch aus Figur 2a ersichtlich ist die Bandbreite des FM-Signals g(k) und auch des bandbegrenzten FM-Signals d(k) deutlich größer als die des modulierenden Signals v(k), beispielsweise bei UKW-Stereo 300 kHz zu 60 kHz.

Daher kann das modulierende Digital-Signal v(kT) auch mit niedrigerer Abtastfrequenz $f_A/P$ angeliefert werden mit

$$v' = v(kPT) \qquad\qquad (6),$$

wobei P aus Aufwandsgründen, aber nicht zwingend, ganzzahlig gewählt werden sollte.

In diesem Fall ist an beliebiger Stelle zwischen Quelle Q bzw. nach dem Analog-Digital-Umsetzer ADU und dem komplexen Oszillator COSZ die Abtastfrequenz mittels eines Interpolations-Filters oder durch eine Kaskade von mehreren um den Faktor P zu erhöhen.

Die Multiplikation mit $2\pi$ vor dem komplexen Oszillator COSZ gemäß Figur 1 kann entfallen, wenn die Adressen für die COSZ-Tabelle entsprechend normiert werden: Adressraum [0,1] Modulo 1 statt [0,2π] Modulo 2π.

Die Tabelle des komplexen Oszillators COSZ kann in folgenden Varianten aufgebaut sein:

1. Zwei Tabellen gleichen Inhalts werden mit unterschiedlichen Adressen angesteuert, wobei die Adressendifferenz $\Delta \varphi = \pi/2$ ist, und gleichzeitig parallel ausgelesen.
2. Es gibt eine gemeinsame Tabelle für Real- und Imaginärteil; diese Tabelle wird für Real- und Imaginärteil sequentiell angesteuert und ausgelesen.
3. Es gibt eine Tabelle für Realteil und eine Tabelle für Imaginärteil, beide sind so angeordnet, daß für eine Adresse der Realteil aus der einen und der Imaginärteil aus der anderen Tabelle gleichzeitig und parallel geliefert werden.

Die Abtastwerte der komplexen Schwingung gemäß Gl. (3) lassen sich aber auch jeweils aktuell berechnen, z.B. mit Hilfe ausreichend genauer Reihenentwicklungen.

Die Filter mit komplexen Koeffizienten lassen sich im allgemeinsten Fall mit 4 Teilfiltern mit jeweils reellen und paarweise gleichen Koeffizienten realisieren, siehe Figur 4, wodurch der Aufwand ebenfalls erheblich gesenkt wird. Interpolations-Filter, deren Ausgangs-Abtast-Frequenz für verfügbare Bausteine sehr hoch oder zu hoch ist so daß die Realisierung Schwierigkeiten bereitet oder überhaupt nicht möglich ist, lassen sich als sogenannte Polyphasenfilter Netzwerke realisieren, siehe hierzu
Deutsches Patent 40 26 476.9.

Die komplexen Filter F und CIPF können zu einem einzigen komplexwertigen Filter zusammengefaßt werden, was ebenfalls eine Aufwandsverminderung sein kann.

Aufgabe der vorliegenden Zusatzanmeldung war es, das Verfahren gemäß der Hauptanmeldung mit noch weniger Aufwand zu ermöglichen.

Die Lösung erfolgt durch die Merkmale des Anspruches 1. vorteilhaft Ausgestaltungen ergeben sich durch die Unteransprüche.

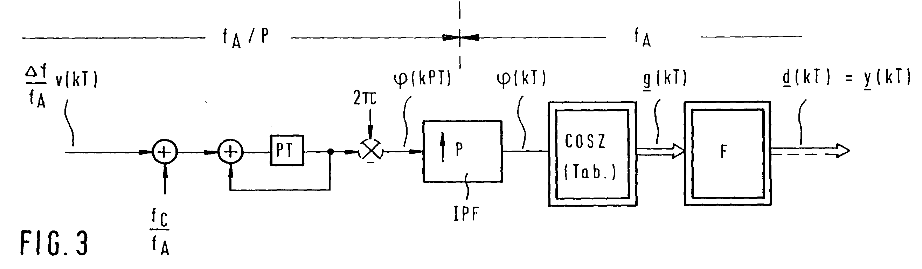

Anstelle des komplexen Interpolationsfilters CIPF gemäß Figur 1 wird deshalb gemäß Figur 3 ein Interpolationsfilter in den reellwertigen Signalzweig eingefügt. Im Beispiel der Figur 3 ist dieses reelle Interpolationsfilter IPF mit dem Interpolationsfaktor P direkt vor dem komplexen Oszillator COSZ eingefügt. Es kann aber auch auf dem Signalweg weiter vorne eingefügt sein. Eine weitere Aufwandsverminderung ergibt eine Realisierung des Interpolationsfilters IPF mittels einer Kaskade von hintereinander geschalteten Teilfiltern mit I Interpolationsteilfaktoren $P_i$, wobei

$$P = \prod_{i=1}^{I} P_i$$

ist und sinnvollerweise $P_i$ (>1) eine ganze Zahl ist.

**Patentansprüche**

1. Verfahren zur FM-Modulation eines digitalen Trägersignals (fc) mit einem digitalen NF-Signal v(kT) mittels eines rückgekoppelten Phasenakkumulators und eines Trägeroszillators, welcher numerisch gesteuert die Abtastwerte der modulierten FM-Schwingung bzw. des FM-Signals erzeugt, dadurch gekennzeichnet, daß das modulierende NF-Signal, mit der Abtastrate $f_A/P$ abgetastet wird mit P > 1,

   daß vor oder nach dem rückgekoppelten Phasenakkumulator mittels eines eingefügten Interpolationsfilters (IPF) die Abtastrate um den Faktor P interpoliert (erhöht) und das NF-Signal gefiltert wird,
   daß als Trägeroszillator ein komplexer Oszillator mit der Abtastrate $f_A$ arbeitet, ein komplexwertiges FM-Trägersignal ($\underline{g}(kT)$) erzeugt, wobei die modulatorausgangsseitige Trägerfrequenz des nichtmodulierten Trägers $f_C = M \cdot f_A/P + f_0$ mit der ganzen Zahl M > 1 und $f_0$ eine Hilfsfrequenz sind, und
   daß anschließend mittels eines komplexwertigen Filters (F) eine Bandbegrenzung des komplexwertigen FM-Trägersignales ($\underline{g}(kT)$) erfolgt ($\underline{d}(kT)$; $\underline{y}(kT)$).

2. Verfahren nach Anspruch 1, dadurch gekennzeichnet, daß diese Bandbegrenzung des FM-Signals auf die UKW-Bandbreite von 300 kHz erfolgt.

3. Verfahren nach Anspruch 1 oder 2, dadurch gekennzeichnet, daß aus diesem bandbegrenzten FM-Signal ($\underline{y}$) durch Berechnung des Real- oder Imaginärteils ein reellwertiges FM-Ausgangs-Signal (y(kT)) erzeugt wird.

4. Verfahren nach Anspruch 3, dadurch gekennzeichnet, daß das reellwertige FM-Ausgangs-Signal digital- analog-umgesetzt wird.

5. Verfahren nach Anspruch 4, dadurch gekennzeichnet, daß das analoge FM-Ausgangs-Signal mittels eines analogen Glättungsfilters (ABP, ATP) geglättet wird (y(t)).

6. Verfahren nach einem der vorhergehenden Ansprüche, dadurch gekennzeichnet, daß an einer beliebigen Stelle vor dem komplexen Oszillator (COSZ) eine Multiplikation mit $2\pi$ erfolgt.

7. Verfahren nach einem der vorhergehenden Ansprüche, dadurch gekennzeichnet, daß vor dem Phasenakkumulator eine Konstante $f_C/f_A$ bzw. $2\pi f_C/f_A$ addiert wird zur Festlegung der ausgangsseitigen Mittenfrequenz $f_C$ des modulierten FM-Signals.

8. Verfahren nach einem der vorhergehenden Ansprüche, dadurch gekennzeichnet, daß im komplexen Oszillator (COSZ) die Abtastwerte der modulierten FM-Schwingung aus einer Tabelle ausgelesen werden.

9. Verfahren nach Anspruch 8, dadurch gekennzeichnet, daß die Tabelle des komplexen Oszillators (COSZ) zwei Teile mit gleichem Inhalt aber mit unterschiedlichen Adressen enthält, die zur Lieferung des Real- und Imaginärteils des komplexwertigen FM-Trägersignals gleichzeitig angesteuert und ausgelesen werden.

10. Verfahren nach Anspruch 8, dadurch gekennzeichnet, daß die Tabelle des komplexen Oszillators (COSZ) aus einem Sinus- und einem Cosinusteil besteht, die unter der gleichen Adresse jeweils gleichzeitig angesteuert und ausgelesen werden.

11. Verfahren nach Anspruch 8, dadurch gekennzeichnet, daß die Tabelle des komplexen Oszillators (COSZ) nur eine einzige Werttabelle für Real- und Imaginärteil umfaßt, die sequentiell angesteuert und ausgelesen werden.

12. Verfahren nach einem der Ansprüche 1 bis 7, dadurch gekennzeichnet, daß die aktuellen Abtastwerte der komplexen FM-Schwingung jeweils mittels eines speziellen Rechenwerkes berechnet werden.

13. Verfahren nach einem der vorhergehenden Ansprüche, dadurch gekennzeichnet, daß P eine ganze Zahl ist.

**Claims**

1. Method for FM modulating a digital carrier signal (fc) with a digital AF signal v(kT) by means of a feedback-type phase accumulator and a carrier oscillator which, controlled numerically, generates the samples of the modulated FM oscillation or, respectively, of the FM signal, characterized in that the modulating AF signal is sampled at the sampling rate $f_A/P$, where $P > 1$, that, preceding or following the feedback-type phase accumulator, the sampling rate is interpolated (increased) by the factor P by means of an inserted interpolation filter (IPF) and the AF signal is filtered,

that as carrier oscillator, a complex oscillator operating at the sampling rate $f_A$ generates a complex-valued FM carrier signal ($\underline{g}(kT)$), wherein the carrier frequency of the unmodulated carrier $f_C = M \cdot f_A/P + f_0$ at the modulator output, where the integral number M >1 and $f_0$ are an auxiliary frequency and that subsequently the complex-valued FM carrier signal ($\underline{g}(kT)$) is band-limited ($\underline{d}(kT);\underline{y}(kT)$) by means of a complex-valued filter (F).

2. Method according to Claim 1, characterized in that this band-limiting of the FM signal is to the VHF bandwidth of 300 kHz.

3. Method according to Claim 1 or 2, characterized in that a real-valued FM output signal (y(kT)) is generated from this band-limited FM signal (y) by calculating the real or imaginary part.

4. Method according to Claim 3, characterized in that the real-valued FM output signal is digital/analog-converted.

5. Method according to Claim 4, characterized in that the analog FM output signal is smoothed (y(t)) by means of an analog smoothing filter (ABP, ATP).

6. Method according to one of the preceding claims, characterized in that a multiplication by $2\pi$ is carried out at any point preceding the complex oscillator (COSZ).

7. Method according to one of the preceding claims, characterized in that, preceding the phase accumulator, a constant $f_C/f_A$ or, respectively, $2\pi f_C/f_A$ is added for establishing the output centre frequency $f_C$ of the modulated FM signal.

8. Method according to one of the preceding claims, characterized in that the samples of the modulated FM oscillation are read out of a table in the complex oscillator (COSZ).

9. Method according to Claim 8, characterized in that the table of the complex oscillator (COSZ) contains two parts having the same content but different addresses which are simultaneously selected and read out for supplying the real and imaginary part of the complex-valued FM carrier signal.

10. Method according to Claim 8, characterized in that the table of the complex oscillator (COSZ) consists of a sine and a cosine part which are in each case simultaneously selected and read out under the same address.

11. Method according to Claim 8, characterized in that the table of the complex oscillator (COSZ) only comprises a single value table for real and imaginary parts which are sequentially selected and read out.

12. Method according to one of Claims 1 to 7, characterized in that the current samples of the complex FM oscillation are in each case calculated by means of a special arithmetic and logic unit.

13. Method according to one of the preceding claims, characterized in that P is an integral number.

**Revendications**

1. Procédé de modulation MF d'un signal de porteuse numérique ($f_C$) par un signal numérique BF (v(kT)) à l'aide d'un accumulateur de phase à réaction et d'un oscillateur de porteuse commandés numériquement, pour générer les valeurs de détection de l'oscillation MF modulée ou du signal MF,
caractérisé en ce que

- le signal de modulation BF est détecté à la vitesse de détection $f_A/P$ avec $P > 1$, et, en amont ou en aval de l'accumulateur de phase à réaction, à l'aide d'un filtre à interpolation (IPF), inséré, on interpole (on augmente) le taux de détection du coefficient P et on filtre le signal BF,
- comme oscillateur de porteuse on utilise un oscillateur complexe avec un coefficient de détection $f_A$,
- on génère un signal de porteuse MF, complexe ($\underline{g}(kT)$),

**EP 0 631 376 B1**

- la fréquence de porteuse à la sortie du modulateur pour la porteuse non modulée est égale à $f_C = M \cdot f_A/P + f_0$, avec M nombre entier > 1 et $f_0$ la fréquence auxiliaire, puis
- on effectue une limitation de bande du signal de porteuse MF, complexe, ($\underline{g}(kT)$) à l'aide d'un filtre complexe (F) [($\underline{d}(kT)$ ; $\underline{y}(kT)$].

**2.** Procédé selon la revendication 1,
caractérisé en ce que
cette limitation de bande du signal MF se fait dans la largeur de bande FM de 300 kHz.

**3.** Procédé selon la revendication 1 ou 2,
caractérisé en ce qu'
à partir de ce signal MF à bande limitée ($\underline{y}$), par calcul de la partie réelle ou imaginaire, on génère une valeur réelle du signal de sortie MF (y(kT)).

**4.** Procédé selon la revendication 3,
caractérisé en ce que
le signal de sortie MF de valeur réelle subit une conversion numérique-analogique.

**5.** Procédé selon la revendication 4,
caractérisé en ce que
le signal de sortie MF, analogique, est lissé par un filtre de lissage analogique (ABP, ATP) (y(t)).

**6.** Procédé selon l'une quelconque des revendications précédentes,
caractérisé en ce qu'
à un emplacement quelconque, en amont de l'oscillateur complexe (COSZ), on fait une multiplication par $2\pi$.

**7.** Procédé selon l'une quelconque des revendications précédentes,
caractérisé en ce qu'
en amont de l'accumulateur de phase, on additionne une constante $f_C/f_A$ ou $2\pi\, f_C/f_A$ pour fixer la fréquence centrale $f_C$ de sortie du signal modulé MF.

**8.** Procédé selon l'une des revendications précédentes,
caractérisé en ce que
dans l'oscillateur complexe (COSZ) on extrait, d'un tableau, les valeurs de détection de l'oscillation MF, modulées.

**9.** Procédé selon la revendication 8,
caractérisé en ce que
le tableau de l'oscillateur complexe (COSZ) comprend deux parties de même contenu mais d'adresses différentes, ces deux parties étant commandées simultanément pour fournir la partie réelle et la partie imaginaire du signal de porteuse MF de valeur complexe.

**10.** Procédé selon la revendication 8,
caractérisé en ce que
le tableau de l'oscillateur complexe (COSZ) se compose d'une partie sinus et d'une partie cosinus qui sont commandées et lues sous la même adresse et en même temps.

**11.** Procédé selon la revendication 8,
caractérisé en ce que
le tableau de l'oscillateur complexe (COSZ) ne comporte qu'un seul tableau pour la partie réelle et la partie imaginaire, pour être commandé séquentiellement et lu dans les mêmes conditions.

**12.** Procédé selon l'une des revendications 1 à 7,
caractérisé en ce que
les valeurs de détection actuelles de l'oscillation complexe MF sont calculées chaque fois à l'aide d'un calculateur particulier.

**13.** Procédé selon l'une quelconque des revendications précédentes,
caractérisé en ce que

7

P est un nombre entier.

FIG. 1

EP 0 631 376 B1

FIG.2a

$\underline{G}(e^{j\Omega})$
$\underline{H}_F(e^{j\Omega})$

Grundperiode ($f_A$)

$\underline{G}$
$\underline{H}_F$

FM-Band-breite

$f_0$   $f_A$   $2f_A$   $3f_A$   $f_C = 3f_A + f_0$   $4f_A$

M

FIG.2b

$\underline{D}(e^{j\Omega/L})$
$\underline{H}_{ClPF}(e^{j\Omega/L})$

$\underline{D}$
$\underline{H}_{ClPF}$

$f_0$   $f_A$   $2f_A$   $3f_A$   $f_C$   $4f_A$

FIG.2c

$\underline{Y}(e^{j\Omega/L})$

$\underline{D}$
$\underline{Y}$

$f_A$   $2f_A$   $3f_A$   $f_C$   $4f_A$

FIG.2d

$Y(e^{j\Omega/L})$
$= \mathrm{Re}\{\underline{Y}\}$

$|H_{ABP}|$

Kehrlage bezüglich $f_C$

Regellage

$|H_{ABP}|$

$f_C'$   $f_A$   $2f_A$   $3f_A$   $f_C$   $f_A' = 4f_A$

FIG.2e

$|Y(j\omega)|$

symmetrisch zu $2\pi f = \omega = 0$

$|Y|$

$f_A$   $2f_A$   $3f_A$   $f_C$   $4f_A$

10

FIG. 3

# FIG. 4

EP 0 631 376 B1

x'(t) ────●──── [ h'(t) ] ──────────── + ⊕ ──→ y'(t)
                                          −

                         [ h"(t) ]

                         [ h"(t) ]

x"(t) ────●──── [ h'(t) ] ──────────── + ⊕ ──→ y"(t)
                                          +

Komplexe Faltung